# EUROPEAN PATENT APPLICATION

(11) **EP 4 535 021 A1**
(43) Date of publication of application: **09.04.2025**
(21) Application number: 23201145.2
(22) Date of filing: 02.10.2023
(51) Int. Cl.: G01R 31/389, B60L 58/00

(54) **A VEHICLE MAINTENANCE METHOD FOR ASSESSING A BATTERY STATE OF AN ELECTROCHEMICAL TRACTION BATTERY MOUNTED TO A VEHICLE**

(71) Applicant: Novum engineerING GmbH, 01067 Dresden (DE)
(72) Inventor: Schipke, Mandy, 01307 Dresden (DE)
(74) Representative: Ter Meer Steinmeister & Partner

(57) **Abstract**

A vehicle maintenance method for assessing a battery state of an electrochemical traction battery (10) of a vehicle (100), including: connecting (S110) a mobile measurement device (20) to the vehicle (100) for establishing an electrical connection of the mobile measurement device (20) to the traction battery (10) in its mounted state in the vehicle (100); performing a maintenance measurement (S130) to obtain maintenance measurement data (72), including measuring an electrical impedance spectrum of the traction battery (10); transmitting (S140) the maintenance measurement data (72) to a server (80); and evaluating (S160) the maintenance measurement data (72) using a trained machine learning algorithm (84) on the server (80), including processing the measured electrical impedance spectrum and generating an output that represents battery state information (74); communicating (S170) the battery state information (74) to the mobile communication device (50); and outputting (S180) the battery state information (74) to a user.

## Description

The invention relates to a vehicle maintenance method for assessing a battery state of an electrochemical traction battery of a vehicle, for example, a traction battery of an industrial vehicle such as an industrial truck or forklift, a truck, a construction machine, etc., or a traction battery of an electric locomotive, etc..

### Summary of the invention

Electric vehicles heavily rely on batteries for power, making it crucial to test the remaining capacity of the batteries for ensuring their optimal performance, efficiency, and safety. Typically, a battery removal is necessary for accurate and reliable capacity testing. However, the removal of the battery is associated with certain disadvantages. Removing the battery from an industrial vehicle for capacity testing means taking the vehicle out of operation temporarily. This downtime can impact productivity and disrupt workflow. Battery removal requires skilled technicians, specialized equipment, and additional time. The process of removing and reinstalling the battery can carry a risk of damage or mishandling of the battery.

It is an object of the present invention to provide a vehicle maintenance method that simplifies assessing a battery state of an electrochemical traction battery of a vehicle.

It is desirable that the method allows for assessing a battery state of batteries of a same kind in a simple and time-saving manner.

It is desirable that the battery state of a battery can be assessed without requiring knowledge of the battery history and without reading a battery management system of the battery.

The invention is indicated in the independent claims. Further embodiments are indicated in the dependent claims.

According to one aspect of the invention, there is provided a vehicle maintenance method for assessing a battery state of an electrochemical traction battery that is mounted to a vehicle, using a mobile communication device (50) and a mobile measurement device configured for performing an electrical impedance spectrum measurement on an electrochemical battery electrically connected to the mobile measurement device (20), the method comprising:
connecting the mobile measurement device to the vehicle for establishing an electrical connection of the mobile measurement device to the traction battery in its mounted state in the vehicle;
performing a maintenance measurement on the traction battery to obtain maintenance measurement data, wherein the maintenance measurement is performed by the mobile measurement device while the traction battery is in its mounted state in the vehicle, and wherein performing the maintenance measurement includes measuring an electrical impedance spectrum of the traction battery;
transmitting the maintenance measurement data from the mobile measurement device to the mobile communication device;
transmitting the maintenance measurement data from the mobile communication device to a server via a communication network; and
evaluating the maintenance measurement data using a trained machine learning algorithm on the server,
wherein evaluating the maintenance measurement data using the trained machine learning algorithm includes:
   inputting the measured electrical impedance spectrum of the traction battery to the machine learning algorithm,
   processing the measured electrical impedance spectrum by the machine learning algorithm, and
   generating an output by the machine learning algorithm, wherein the output represents battery state information associated with the traction battery,
wherein the method further includes:
   communicating the battery state information associated with the traction battery to the mobile communication device via the communication network; and
   outputting, by the mobile communication device or the mobile measurement device, the battery state information to a user.

For example, the vehicle may be a forklift, a truck, a construction machine or any other kind of battery driven industrial vehicle, or an electric locomotive. In particular, the vehicle may be an electric vehicle or a hybrid vehicle.

By using a mobile communication device for communication with the server, the steps performed by the mobile communication device may be performed by an all-purpose mobile communication device. Moreover, a mobile communication unit may easily be used at the vehicle, for example, on site. For example, the mobile communication device may be mobile computing and communication device. For example, the mobile communication device may be a laptop, a tablet computer, or a mobile phone such as a smartphone. The mobile communication device may be configured for controlling the mobile measurement device. The mobile communication device may include a software configured for controlling the mentioned steps to be performed by the mobile measurement device. For example, the mobile communication device may include an application software configured for controlling the mobile measurement device to perform the mentioned steps performed by the mobile measurement device. In particular, the mobile measurement device may be controlled to perform the respective steps of the method. For example, the application software may be configured for controlling the mobile measurement device to perform one or more of the following steps: performing the maintenance measurement on the traction battery to obtain maintenance measurement data; transmitting the maintenance measurement data from the mobile measurement device to the mobile communication device. The mobile communication device may include software configured for performing the mentioned steps performed by the mobile communication device. For example, the mobile communication device may include the or an application software configured for performing one or more of the following steps: receiving the maintenance measurement data from the mobile measurement device; transmitting the maintenance measurement data to the server via the communication network; obtaining the battery state information associated with the traction battery from the server via the communication network; outputting the battery state information to a user.

The mobile measurement device may also be termed a portable measurement device. For example, the mobile measurement device may comprise measurement connectors for connecting the mobile measurement device to the vehicle and/or to the traction battery mounted in the vehicle. For example, the measurement connectors may be configured for connecting the mobile measurement device to battery poles of the traction battery in its mounted state in the vehicle. For example, the measurement connectors may be configured for enabling a 4-terminal-measurement (or Kelvin measurement) of the battery. This is particularly important for accurately measuring electrical impedance. Thus, a 4-terminal-electrical connection of the mobile measurement device to the traction battery may be established. For example, the measurement connectors may be flexible measurement connectors, which may be integrated in a flexible connection cable. For example, the measurement connectors may be arranged to extend outside a housing of the mobile measurement device. For example, the mobile measurement device may be configured to be controlled by the mobile communication device to perform the steps of performing the maintenance measurement on the traction battery to obtain maintenance measurement data; and/or transmitting the maintenance measurement data from the mobile measurement device to the mobile communication device.

By the vehicle maintenance method, a simple and user-friendly method is provided that allows for assessing a battery state of an electrochemical traction battery of a vehicle while the traction battery is in its mounted state in the vehicle. The method allows for assessing a battery state of the mounted traction battery in a simple and time-saving manner by connecting the mobile measurement device to the vehicle or, in particular, to the traction battery and performing a maintenance measurement by the mobile measurement device. That is, for the electrochemical traction battery mounted to the vehicle an electrical impedance spectrum of the battery is measured by the mobile communication device.

The vehicle maintenance method may allow for assessing an electrochemical traction battery that is mounted to a vehicle, independently of the battery history of the traction battery and, in particular, without reading a battery management system of the traction battery. Thus, the battery state may be reliably assessed, even if the exact battery history is not available.

Thus, the vehicle maintenance method may allow to quickly and reliably assess the battery status of the electrochemical traction battery that is mounted to the vehicle, thereby making it possible to estimate, for example, the remaining capacity of the battery. Thus, the method may allow for ensuring optimal performance, efficiency, and safety of the traction battery without removing the battery from the vehicle.

The vehicle maintenance method simplifies the assessment of the battery state of the electrochemical traction battery. Keeping the battery in the vehicle while assessing the battery state allows a user to save money by preventing a downtime when the vehicle is temporarily out of operation caused by a removal of the battery from vehicle. Moreover, the requirements on skilled technicians and specialized equipment and a risk of damage while removing and reinstalling the battery are lowered.

The vehicle maintenance method may be a method for on-site assessing a battery state of an electrochemical traction battery that is mounted to a vehicle. The step of performing a maintenance measurement on the traction battery may be a step of performing on-site a maintenance measurement on the traction battery.

The measured maintenance measurement data is transmitted from the mobile measurement device to the mobile communication device. For example, the mobile measurement device may include a communication unit. In particular, the mobile measurement device may be connected to the mobile communication device via the communication unit of the mobile measurement device, or the mobile measurement device may comprise a wireless communication unit for communicating with the mobile communication device. For example, the mobile measurement device may transmit the maintenance measurement data to the mobile communication device via the communication unit of the mobile measurement. For example, the mobile communication device may include a communication unit. In particular, the mobile communication device may be connected to the mobile measurement device via the communication unit of the mobile communication device, or the mobile communication device may comprise a wireless communication unit for communicating with the mobile measurement device. The communication unit of the mobile measurement device and/or, respectively, of the mobile communication device may include a serial data communication interface, such as a universal serial bus interface, a Bluetooth communication unit, or any other communication link in the state of the art.

The mobile communication device is configured for transmitting the maintenance measurement data to a server via a communication network. In particular, the mobile communication device may be configured for transmitting the maintenance measurement data via a mobile communication unit of the mobile communication device to the server. The server may be a remote server. The communication network may be a remote communication network. For example, the communication network may include the internet and/or a mobile communication network. Thus, mobile communication device and the server may be configured for remote communication. For example, the server may include a communication unit. In particular, the server may be configured to communicate with the mobile communication device via the communication unit of the server.

The method may include performing an electrical impedance spectrum (EIS) measurement on the traction battery in its mounted state in the vehicle, the electrical impedance spectrum (EIS) measurement including said measuring of an electrical impedance spectrum of the traction battery. The electrical impedance spectrum measurement may also be called an electrical impedance spectroscopy measurement. Measuring an electrical impedance spectrum of the traction battery may include recording the electrical impedance spectrum. Using electrochemical impedance spectroscopy, electrochemical processes in an electrochemical battery are characterized by electrical measurements that characterize the AC response of the electrochemical battery to an applied AC signal. The chemical processes in the battery, in addition to the structural configuration and the configuration of the internal connectors, lead to characteristic frequency dependencies of the measured impedance. During the measurement of an electrical impedance at a specific measurement frequency, a DC offset signal (an offset voltage or an offset current) or DC bias signal may be applied to the battery, which is modulated by the AC signal of the measurement frequency.

The EIS measurement or the measuring of an electrical impedance spectrum may include a number of electrical impedance measurements at different measurement frequencies. For example, the number of different measurement frequencies may be at least four, at least eight, at least 16, at least 32, or at least 64. For example, the respective measurement frequency may be a frequency of a signal input to the electrochemical battery. For example, the signal may be a sinusoidal signal. Preferably, each electrical impedance value of the measured electrical impedance spectrum comprises a complex number that defines a real part and an imaginary part of a respective electrical impedance. That is, the spectrum is a complex spectrum. Preferably, the measured electrical impedance spectrum is in a digitally represented form. The electrical impedance for the respective measurement frequencies may be measured in any order and/or concurrently.

Preferably, the measurement frequencies include a measurement frequency in the range of 0.1 to 1.0 Hz. Preferably, the measurement frequencies include a measurement frequency in the range of 1 kHz to 10 kHz. Preferably, the number of different measurement frequencies in the range of 0.1 Hz to 5000 Hz is at least four, at least eight, at least 16, at least 32, or at least 64. Preferably, the measurement frequencies include at least 4 (four) measurement frequencies per decade of the measurement frequency range, more preferably at least five measurement frequencies per decade of the measurement frequency range.

The maintenance measurement data is evaluated using a trained machine learning algorithm on the server. In particular, the machine learning algorithm is configured for receiving a measured electrical impedance spectrum of a battery as an input. The machine learning algorithm may be a machine learning algorithm trained based at least on training measurement data for each of a number of batteries of a same kind as the traction battery. The training measurement data may include a remaining battery capacity of a respective battery and an electrical impedance spectrum of the respective battery.

In the present disclosure, batteries of a same kind are to be understood as including batteries having the same nominal battery parameters or nominal characteristics (battery parameters/characteristics according to the manufacturer), in particular, a same nominal voltage, a same nominal electrical capacity (e.g. in mAh), and a same nominal energy capacity (e.g. in Wh), if applicable. In the present disclosure, the method may also be applied to batteries of a same kind that are selected based on a common and/or similar use case or location of use, when no battery parameter differences are known, or when the batteries are of a same kind according to their appearance. Battery parameters that may be taken into account may include at least one of a voltage rating, a capacity rating, an energy rating, a nominal voltage, a nominal battery capacity (for example, in mAh), a nominal energy capacity (for example, in Wh), a manufacturer's battery type information or code, battery cell chemistry information, a voltage per battery cell, a number of battery cells in the battery, etc. In the present disclosure, the terms "batteries of a same kind" or "battery of the same kind" refer to the kind of battery. The kind of battery may include a type of battery (or battery type).

Herein, the term "battery" or, in particular, "traction battery" is to be understood as including a battery cell. The battery may include one or more battery cells. In particular, the term "battery" includes a battery cell as well as a battery composed of multiple battery cells. Specifically, the electrochemical (traction) battery is understood as defining a device consisting of one or more electrochemical cells with external electrical connections. For example, the battery may include two external electrical connections for drawing power from the one or more electrochemical cells and, in case of a rechargeable electrochemical battery, for (re-)charging the one or more electrochemical cells. For example, the electrochemical battery may be a lithium-ion battery or a lead acid battery.

For example, the machine learning algorithm may be or may include at least one of: an artificial neural network, a support vector machine, a k-nearest neighbors algorithm, and a machine learning decision tree.

The neural network may be configured for processing a measured electrical impedance spectrum. For example, the neural network may include a deep neural network (DNN). A deep neural network has an input layer, more than one hidden layer, and an output layer. For example, the neural network may include a convolutional neural network (CNN). A convolutional neural network has an input layer, at least one convolutional layer, and an output layer. A CNN may be a deep neural network.

For example, the machine learning algorithm may be configured for processing the measured electrical impedance spectrum to generate the output. The machine learning algorithm may be a machine learning algorithm trained based on training measurement data for at least one kind of batteries. For example, training the machine learning algorithm may be performed using training measurement data. The trained machine learning algorithm is used for evaluating the maintenance measurement data. For example, the trained machine learning algorithm may be applied to the maintenance measurement data, in particular the electrical impedance spectrum of the traction battery, by inputting the electrical impedance spectrum of the traction battery to the machine learning algorithm. The machine learning algorithm is processing the electrical impedance spectrum and generates an output. For example, the server may include a software configured to perform the steps of inputting the measured electrical impedance spectrum of the battery to the machine learning algorithm, processing the measured electrical impedance spectrum by the machine learning algorithm, and generating an output by the machine learning algorithm. The electrical impedance spectrum is used as an input in the step of inputting the measured electrical impedance spectrum, and a battery state may be an output (a target value) in the step of generating an output by the machine learning algorithm. Thus, the output that represents battery state information may be determined based on the processing of the measured electrical impedance spectrum by the machine learning algorithm. For example, the output of the machine learning algorithm may be called a prediction. In particular, the battery state information that is output to the user may be the output of the machine learning algorithm.

The server is communicating the generated battery state information associated with the traction battery to the mobile communication device via the communication network. The mobile communication device may output the battery state information associated with the traction battery to a user. For example, outputting the battery state information may be performed by the mobile communication device or the mobile measurement device.

For example, the server may be configured for communicating the output of the machine learning algorithm to the mobile communication device through the communication network. For example, the server may be configured for transmitting the battery state information to the mobile communication device through the communication network.

For example, the mobile communication device may be configured for outputting the output of the machine learning algorithm to a user. For example, the mobile communication device or the mobile measurement device may be configured for outputting the battery state information according to the output of the machine learning algorithm to a user. For example, the mobile measurement device or the mobile communication device may include an output unit configured for outputting the battery state information to a user.

In the present disclosure, when the mobile measurement device, the mobile communication device or the server is configured for transmitting measurements, data, or information to the server, the mobile measurement device, or the mobile communication device, respectively, the respective server, mobile measurement device, or mobile communication device may be configured for receiving said measurements, data, or information, correspondingly.

For example, the battery state information may be outputted by the mobile communication device or the mobile measurement unit via an output unit, such as a display, a printer, and/or a computer. The battery state information may be displayed and/or printed. For example, a label may be printed indicating the battery state information.

In embodiments, the method further includes a step of obtaining identification data of the traction battery by the mobile measurement device or by the mobile communication device. Identification data may include at least one of an identification code (such as a serial number) and information related to the battery kind of the traction battery (such as a battery type code).

In embodiments, the step of obtaining identification data of the traction battery includes scanning a battery barcode using an input device. The battery barcode may be scanned from the traction battery, for example. The battery barcode may include the identification data of the traction battery. For example, the mobile measurement device or the mobile communication device may include the input device. The input device may include a scanner or a camera.

For example, based on the obtained identification data, the mobile measurement device, the mobile communication device, or the server may determine information related to the battery kind of the traction battery. The battery kind may include a type of battery or battery type.

In embodiments, the battery state information may include at least one of a remaining battery capacity, a state of health, and a classification. For example, the output of the machine learning algorithm may represent one of a remaining battery capacity, state of health (SoH), and a classification. For example, the output of the machine learning algorithm may be one of an estimated remaining battery capacity, an estimated state of health, and a classification. For example, an estimated state of health (SoH) may be determined by dividing the estimated remaining battery capacity (output by the machine learning algorithm) by a nominal battery capacity associated with the battery kind of the traction battery. This may be expressed by the following equation: SoH = estimated remaining battery capacity / nominal battery capacity. The nominal battery capacity may be a battery capacity of the traction battery in its original condition (or manufacturing condition), according to the battery kind. For example, a classification may be determined according to an estimated state of health and/or according to an estimated battery capacity. This does not exclude that further parameters may be additionally used for determining the classification.

The classification that may be output by the machine learning algorithm and/or by the mobile communication device or the mobile measurement device is a classification of battery state. It may also be termed a battery grade or a battery rating. For example, the classification is selected from a number of classes, categories, grades or ratings. The number is, for example, less than 10, or less than 8, or is in the range of 3 to 6. For example, the number may be 4 or 5. For example, the classes may be "A", "B", "C", and "D". The number may depend on the kind of batteries to be assessed.

For example, when performing the maintenance measurement on the traction battery, there is no battery capacity measurement performed in addition to the electrical impedance spectrum measurement or the measuring an electrical impedance spectrum of the traction battery. Since it is not required to charge or discharge the traction battery, the maintenance measurement may be performed in a short time.

In embodiments, the measured impedance spectrum of the traction battery includes an electrical impedance spectrum of the entire traction battery and/or an electrical impedance spectrum of at least one of a plurality of battery strings of the traction battery. Thus, measuring an electrical impedance spectrum of the traction battery may include measuring an electrical impedance spectrum of the entire traction battery and/or measuring an electrical impedance spectrum of at least one of a plurality of battery strings of the traction battery. For example, the mobile measurement device may be configured for measuring an electrical impedance spectrum of the entire traction battery and/or of at least one of a plurality of battery strings of the traction battery.

The maintenance measurement data may further include a measurement of a direct voltage of the traction battery, or of at least one of a plurality of battery strings of the traction battery.

In embodiments, the step of connecting the mobile measurement device to the vehicle includes connecting the mobile measurement device to a vehicle bus interface of the vehicle, such as a controller area network (CAN) bus. For example, the mobile measurement device may be configured for being connected to a serial data bus of the vehicle. In particular, the mobile measurement device may be configured for being connected to a controller area network (CAN) bus of the vehicle.

In embodiments, the method further includes: selecting at least one of a plurality of battery strings of the traction battery and/or the entire traction battery via the vehicle bus interface of the vehicle for measuring the electrical impedance spectrum, wherein the measured electrical impedance spectrum includes an electrical impedance spectrum of the selected at least one of the plurality of battery strings of the traction battery and/or the entire traction battery. For example, the mobile measurement device may be configured for performing the step of selecting the at least one of the plurality of battery strings of the traction battery and/or the entire traction battery via the vehicle bus interface of the vehicle for measuring the electrical impedance spectrum. In particular, the mobile communication device may be configured for controlling the mobile measurement unit to select the at least one of the plurality of battery strings of the traction battery and/or the entire traction battery via the vehicle bus interface.

In embodiments, the method includes: obtaining identification data of the traction battery by the mobile measurement device via the vehicle bus interface of the vehicle. Thus, the step of obtaining identification data of the traction battery may be performed by the mobile measurement device obtaining identification data of the traction battery via the vehicle bus interface of the vehicle.

In embodiments, the step of connecting the mobile measurement device to the vehicle includes connecting at least one temperature sensor to the battery and/or connecting the mobile measurement device to at least one temperature sensor of the battery. For example, the mobile measurement device may be configured for being connected to at least one temperature sensor of the battery.

In embodiments, the step of performing the maintenance measurement includes measuring a temperature value of the traction battery. In particular, the step of performing the maintenance measurement may include measuring a temperature value of at least one of a plurality of battery strings of the traction battery and/or the entire traction battery, in particular of the selected at least one of a plurality of battery strings of the traction battery and/or the entire traction battery. In particular, the maintenance measurement data may include a temperature value of the traction battery. In particular, the maintenance measurement data may include a temperature value of (for example, the selected) at least one of a plurality of battery strings of the traction battery and/or the entire traction battery.

In embodiments, the method includes: caching the maintenance measurement data on the mobile communication device before transmitting the maintenance measurement data from the mobile communication device to the server via the communication network. For example, the step of transmitting the maintenance measurement data from the mobile communication device to the server may include caching of the maintenance measurement data on the mobile communication device. In particular, the mobile communication device may be configured to perform the step of caching the maintenance measurement data on the mobile communication device in case of unavailability of the communication network. The mobile communication device may be configured to perform the step of transmitting the cached maintenance measurement data from the mobile communication device to the server in case of availability of the communication network.

In embodiments, the method further includes: training the machine learning algorithm using the maintenance measurement data as training measurement data. The server may be configured to perform the step of training the machine machine learning algorithm by using the maintenance measurement data as training measurement data. For example, the step of training may be performed automatically. Thus, the step of training the machine learning algorithm (e.g. a neural network) based on the maintenance measurement data as training measurement data may be a self-learning or self-training of the machine learning algorithm or neural network. In the present disclosure, the terms self-learning and self-training are used synonymously.

In embodiments, the machine learning algorithm is a machine learning algorithm trained based on training measurement data for each of a number of batteries of at least two different kinds of batteries. Information related to the (identified) battery kind (kind of battery), and/or the identification data may additionally be transmitted to the server, for example, as a part of the maintenance measurement data. Information related to the battery kind may additionally be input to the machine learning algorithm. Additionally or alternatively, in embodiments, the server may be configured to provide (implement) one or more further machine learning algorithms, wherein each machine learning algorithm (including the initially mentioned machine learning algorithm) is associated with a respective battery kind. In particular, training each of the machine learning algorithms may be performed based on respective training measurement data for each battery kind. The server may be configured to perform the step of adapting the machine learning algorithm to the identified kind of battery. In the following, only one machine learning algorithm is described for simplifying the description.

In the following, preferred embodiments of the invention will be described in conjunction with the drawings, in which:
- Fig. 1: shows a schematic illustration of a vehicle maintenance method for assessing a battery state of an electrochemical traction battery that is mounted to a vehicle;
- Fig. 2: shows a schematic illustration of assessing a battery state of an electrochemical traction battery that is mounted to a vehicle using the vehicle maintenance method.

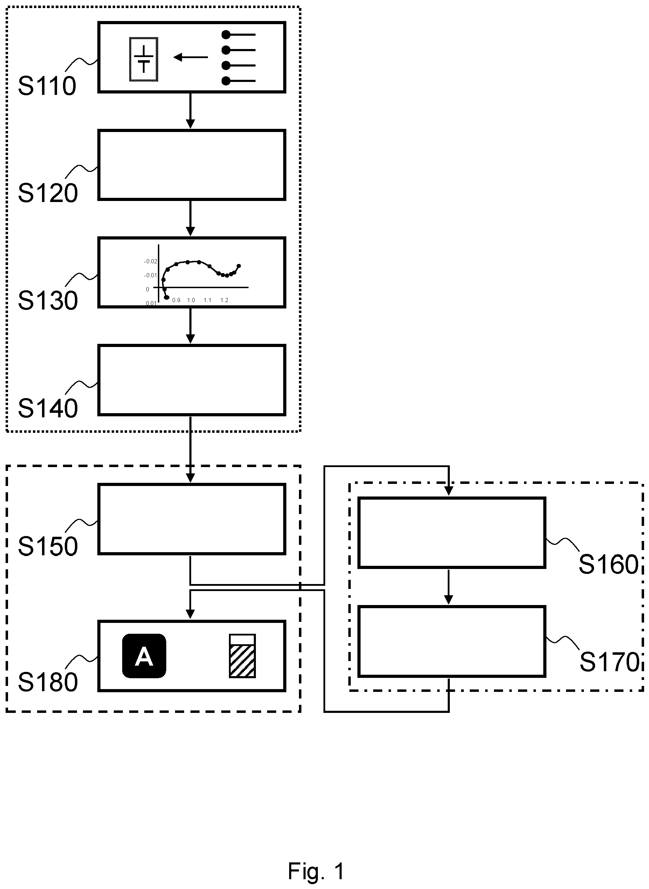

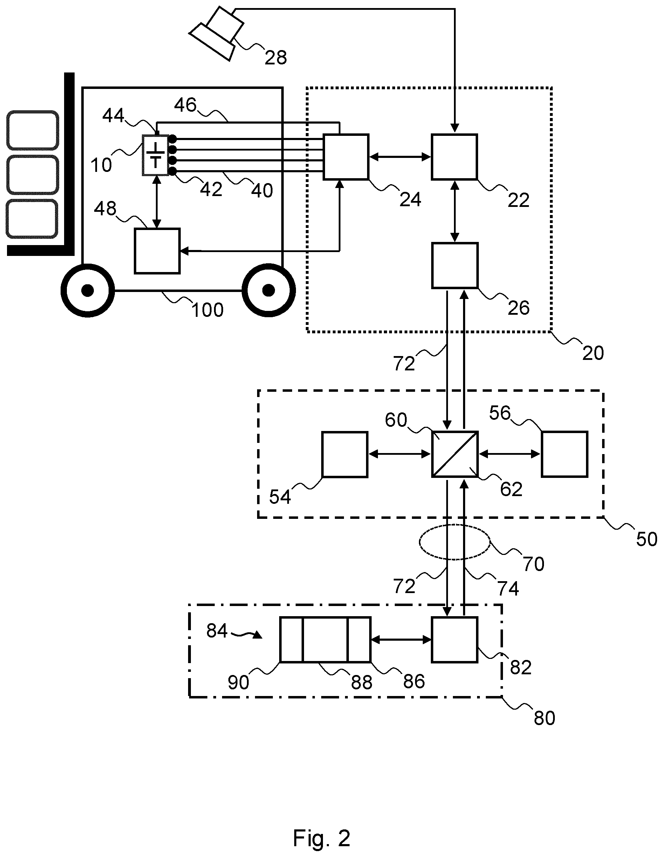

Fig. 1 schematically shows a vehicle maintenance method for assessing a battery state of an electrochemical traction battery that is mounted to a vehicle and Fig. 2 schematically illustrates assessing a battery state of the electrochemical traction battery that is mounted to the vehicle using the vehicle maintenance method shown in Fig. 1.

In step S110, a mobile measurement device 20 is connected to a traction battery 10, mounted to a vehicle 100, through flexible measurement connectors of a flexible cable 40. The traction battery 10 is connected to a measurement unit 24 of the mobile measurement device 20 using the flexible cable 40 having four terminals 42 for connecting the traction battery 10. At least one temperature sensor 44 of the battery 10 or of the mobile measurement device 20 may be connected to the mobile measurement device 20 via a temperature sensor connector 46. The mobile measurement device 20 is furthermore connected to a vehicle bus interface 48 of the vehicle 100, in particular, to a controller area network (CAN) bus of the vehicle 100.

In step S120, identification data including a battery kind of the traction battery 10 may be obtained by the mobile measurement device 20. This may be done by scanning a bar code using an input device 28 or a built-in camera of a mobile communication device 50, or by communicating via the vehicle bus interface 48.

In step S130, the mobile measurement device 20 performs a maintenance measurement on the traction battery 10 to obtain maintenance measurement data 72 while the traction battery 10 is in its mounted state in the vehicle 100. Performing the maintenance measurement S130 includes measuring an electrical impedance spectrum of the traction battery 10. The mobile measurement device 20 may select at least one of a plurality of battery strings of the traction battery 10 and/or the entire traction battery 10 for measuring an electrical impedance spectrum thereof. Several battery strings of the traction battery 10 may be sequentially selected for sequentially measuring a respective electrical impedance spectrum.

Performing the maintenance measurement S130 may include measuring a temperature of the traction battery 10. The temperature measurement may be performed using the temperature sensor 44, or using a built-in temperature sensor of the traction battery 10 that may be read out via the vehicle bus interface 48. Performing the maintenance measurement S130 may include measuring a direct voltage of the traction battery 10.

The measurement unit 24 of the mobile measurement device 20 is controlled by a controller 22 of the mobile measurement device 20. The mobile communication device 50 is configured for controlling the mobile measurement device 20. In particular, the mobile communication device 50 includes a software configured for controlling the mobile measurement device 20 to perform the maintenance measurement. The software may be controller by a user via a graphical user interface 56.

In step S140, the maintenance measurement data 72 is transmitted from the mobile measurement device 20 to the mobile communication device 50. In particular, the measured maintenance measurement data 72 may be transmitted from the mobile measurement device 20 by a communication unit 26 of the mobile measurement device 20 to the mobile communication device 50 via a communication unit 60 of the mobile communication device 50. The mobile communication device 50 may be connected to the mobile measurement device 20, for example, via a serial communication interface such as USB (universal serial bus), or the maintenance measurement data 72 may be transmitted by wireless communication. The maintenance measurement data 72 additionally includes the identification data or the battery kind of the traction battery 10.

In step S150, the maintenance measurement data 72 is transmitted from the mobile communication device 50 to a remote server 80 via a remote communication network 70. In particular, the maintenance measurement data 72 is transmitted by a remote communication unit 62 of the mobile communication device 50 to a remote communication unit 82 of the remote server 80.

The mobile communication device 50 may cache the maintenance measurement data 72 on the mobile communication device 50. In particular, the cached maintenance measurement data 72 may be transmitted from the mobile communication device 50 to the remote server 80 in case of availability of the remote communication network 70 for communication between the mobile communication device 50 and the remote server 80.

In step S 160, the maintenance measurement data 72 is evaluated on the server 80 using a trained machine learning algorithm 84 on the server 80. The server 80 inputs the transmitted maintenance measurement data 72 including the measured electrical impedance spectrum of the traction battery 10 to the trained machine learning algorithm 84. The electrical impedance spectrum of the traction battery 10 is processed by the trained machine learning algorithm 84. The trained machine learning algorithm 84 generates an output representing a battery state information 74 of the traction battery 10. In particular, the battery state information is at least one of remaining battery capacity, state of health (SoH), and a classification. For example, the battery state information 74 may include a state of health as well as a grade or classification of the traction battery 10 that is determined by categorizing the traction battery 10 according to the determined state of health.

The machine learning algorithm 84 of the server 80 includes an artificial neural network having an input layer 86, at least one hidden layer 88, and an output layer 90. The input layer 86 is configured to accept as input the electrical impedance spectrum measured by the mobile measurement device 20. The neural network is configured to process the electrical impedance spectrum and generate therefrom an output 74 at its output layer 90. The output 74 of the machine learning algorithm 84 represents battery state information 74 of the traction battery 10.

In step S170, the battery state information 74 of the traction battery 10 is communicated to the mobile communication device 50 via the remote communication network 70.

In step S180, the battery state information 74 of the traction battery 10 is output by the mobile communication device 50 via an output unit 54, such as a display, to a user. For example, a grade or classification ("A") and a graphical display of the state of health may be output.

## Claims

1. A vehicle maintenance method for assessing a battery state of an electrochemical traction battery (10) that is mounted to a vehicle (100), using a mobile communication device (50) and a mobile measurement device (20) configured for performing an electrical impedance spectrum measurement on an electrochemical battery electrically connected to the mobile measurement device (20), the method comprising:
connecting (S110) the mobile measurement device (20) to the vehicle (100) for establishing an electrical connection of the mobile measurement device (20) to the traction battery (10) in its mounted state in the vehicle (100);
performing a maintenance measurement (S130) on the traction battery (10) to obtain maintenance measurement data (72), wherein the maintenance measurement is performed by the mobile measurement device (20) while the traction battery (10) is in its mounted state in the vehicle, and wherein performing the maintenance measurement (S130) includes measuring an electrical impedance spectrum of the traction battery (10);
transmitting (S140) the maintenance measurement data (72) from the mobile measurement device (20) to the mobile communication device (50);
transmitting (S150) the maintenance measurement data (72) from the mobile communication device (50) to a server (80) via a communication network (70); and
evaluating (S160) the maintenance measurement data (72) using a trained machine learning algorithm (84) on the server (80),
wherein evaluating (S160) the maintenance measurement data (72) using the trained machine learning algorithm (84) includes:
inputting the measured electrical impedance spectrum of the traction battery (10) to the machine learning algorithm (84),
processing the measured electrical impedance spectrum by the machine learning algorithm (84), and
generating an output by the machine learning algorithm (84), wherein the output represents battery state information (74) associated with the traction battery (10), wherein the method further includes:
communicating (S170) the battery state information (74) associated with the traction battery (10) to the mobile communication device (50) via the communication network (70); and
outputting (S180), by the mobile communication device (50) or the mobile measurement device (20), the battery state information (74) to a user.

2. The method according to claim 1, the method further including: obtaining (S120) identification data of the traction battery (10) by the mobile measurement device (20) or by the mobile communication device (50).

3. The method according claim 2, wherein the step of obtaining (S120) identification data of the traction battery (10) includes scanning a battery barcode using an input device (28).

4. The method according to any one of the preceding claims, wherein the battery state information (74) includes at least one of a remaining battery capacity, a state of health, and a classification.

5. The method according to any one of the preceding claims, wherein the measured impedance spectrum of the traction battery (10) includes an electrical impedance spectrum of the entire traction battery (10) and/or an electrical impedance spectrum of at least one of a plurality of battery strings of the traction battery (10) .

6. The method according to any one of the preceding claims, wherein the step of connecting (5110) the mobile measurement device (20) to the vehicle (100) includes connecting the mobile measurement device (20) to a vehicle bus interface (48) of the vehicle (100).

7. The method according to any one of the preceding claims, wherein the method further includes: selecting at least one of a plurality of battery strings of the traction battery (10) and/or the entire traction battery (10) via the vehicle bus interface (48) of the vehicle (100) for measuring the electrical impedance spectrum, wherein the measured electrical impedance spectrum includes an electrical impedance spectrum of the selected at least one of the plurality of battery strings of the traction battery (10) and/or the entire traction battery (10).

8. The method according to any one of the preceding claims, wherein the method includes: obtaining (S120) identification data of the traction battery (10) by the mobile measurement device (20) via the vehicle bus interface (48) of the vehicle (100).

9. The method according to any one of the preceding claims, wherein the step of connecting (S110) the mobile measurement device (20) to the vehicle (100) includes connecting at least one temperature sensor (44) to the battery (10) and/or connecting the mobile measurement device (20) to at least one temperature sensor (44) of the battery (10).

10. The method according to any one of the preceding claims, wherein the step of performing the maintenance measurement (S130) includes measuring a temperature value of at least one of a plurality of battery strings of the traction battery (10) and/or the entire traction battery (10).

11. The method according to any one of the preceding claims, wherein the method includes: caching (S200) the maintenance measurement data (72) on the mobile communication device (50) before transmitting (S150) the maintenance measurement data (72) from the mobile communication device (50) to the server (80) via the communication network (70).

12. The method according to any one of the preceding claims, the method further including: training (S190) the machine learning algorithm (84) using the maintenance measurement data (72) as training measurement data.
